Europäisches Patentamt

European Patent Office

Office européen des brevets

(11) Publication number: **0 290 212**
A2

## EUROPEAN PATENT APPLICATION

(21) Application number: 88303961.2

(51) Int. Cl.⁴: **H01L 23/42**

(22) Date of filing: 29.04.88

(30) Priority: 02.05.87 GB 8710509

(43) Date of publication of application:
09.11.88 Bulletin 88/45

(84) Designated Contracting States:
AT BE CH DE ES FR GR IT LI LU NL SE

(71) Applicant: MARCONI ELECTRONIC DEVICES
LIMITED
The Grove Warren Lane
Stanmore Middlesex HA7 4LY(GB)

(72) Inventor: Lewis, Colin Bright
14 Sudbrooke Lane
Nettleham Lincoln LN2 2RN(GB)
Inventor: Greening-Lewis, Michael John
The Old Vicarage
Rowston Lincoln LN4 3LT(GB)
Inventor: Payne, Michael
3 Clarke road
Doddington Road Lincoln LN6 8SH(GB)

(74) Representative: Tolfree, Roger Keith
GEC p.l.c. Central Patent Department
Chelmsford Office Marconi Research Centre
West Hanningfield Road
Great Baddow Chelmsford Essex CM2
8HN(GB)

(54) Cooling arrangement and method of monitoring its operation.

(57) A cooling arrangement for high power compo-
nents such as semi-conductors includes a chamber,
a lower portion of which contains a liquid to which
heat can be applied to vaporise some of the liquid.
An upper portion of the chamber constitutes a con-
densation region at which vaporise liquid is con-
densed. Means is included for monitoring a dif-
ference in temperature between the upper and lower
portions and which is indicative of an incomplete
filling of the chamber with the liquid and its vapor.

# COOLING ARRANGEMENT AND METHOD OF MONITORING ITS OPERATION

This invention relates to a cooling arrangement and to a method of monitoring its operation. The invention is specifically applicable to phase change cooling in which heat is transferred substantially isothermally from one point to another. The process generally involves the controlled boiling of a fluorocarbon liquid near the source of heat, and the condensation of the resultant vapour in the region of a remote heat exchanger or radiator.

This kind of cooling is very suitable for the cooling of high power components such as semiconductors, which generally dissipate their energy losses via relatively small contact areas producing high heat flux which is difficult to remove by conventional conduction or convection processes. Cooling arrangements of the phase change kind which have been used for the cooling of high power components have not proved completely reliable, and can suffer from a degraded thermal performance which can result in a component being damaged by over-heating.

The present invention seeks to provide an improved such arrangement.

According to a first aspect of this invention a cooling arrangement of the phase change kind includes a chamber, a lower portion of which contains a liquid to which heat can be applied to vaporise some of the liquid and an upper portion of which constitutes a condensation region at which vaporised liquid is condensed, and means for monitoring a difference in temperature between the upper and lower portions and which is indicative of an incomplete filling of the chamber with said liquid and its vapour.

According to a second aspect of this invention a method of monitoring the operation of a phase change cooling arrangement includes the step of determining whether the temperature difference between a heating region of a volatile liquid and a condensation region of gas exceeds a predetermined value.

Preferably the liquid used is a fluorocarbon.

Preferably a heat exchange section is placed between the lower part of the chamber and the upper part. The liquid which is heated in the lower part of the chamber by a high power electrical component or the like boils, which is immersed in it and the resulting vapour is arranged to rise through the heat exchanger section to the upper part where condensation takes place. A substantial amount of condensation takes place in the heat exchanger itself.

Under correct operating conditions the temperature difference between the liquid heating region and the vapour filled condensation region should be very small indeed. The operation of the cooling arrangement is greatly impaired however, if a gas, such as air, is allowed to enter the chamber. The liquid used as the coolant is a volatile one which boils at the temperature at which the component is to be held - a fluorocarbon liquid is commonly used. Suitable fluorocarbons are available under the trade name Freon.

If for any reason during filling of the chamber with the fluorocarbon liquid or during subsequent use an excess of air is present, this can completely fill the upper portion of the chamber or collect in the upper parts of the heat exchanger region which is positioned adjacent to the upper part. The effect of this is to blank off part of the heat exchanger to fluorocarbon vapour, thereby reducing the effective area of the heat exchange and degrading the thermal performance of the system. Such an effect also gives rise to a substantial temperature difference being present between the upper and the lower parts of the chamber.

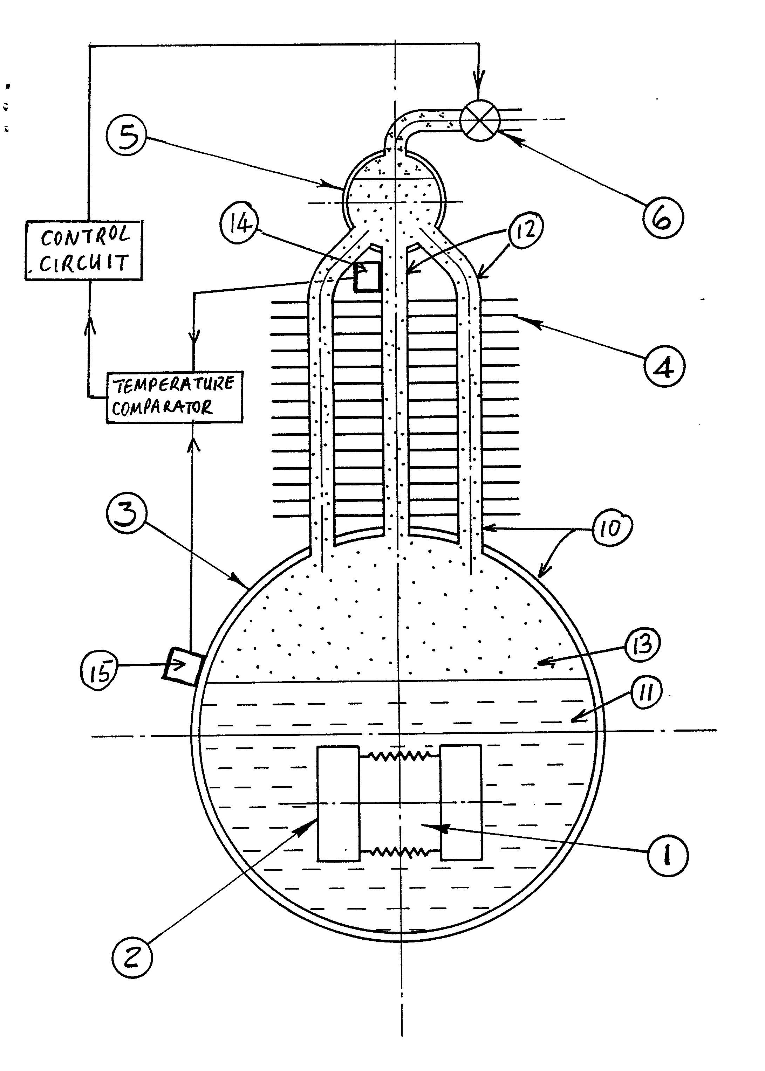

The invention is further described by way of example with reference to the accompanying drawing which illustrates a diagramatic sectional view of cooling arrangement relying on phase change cooling.

Referring to the drawing, the cooling arrangement consists of a chamber designated generally at 10. In use the cooling arrangement is intended to cool high power components, one of which, a semiconductor component 1 is mounted within a lower part termed a tank 3 of the chamber 10, the component 1 being mounted between a pair of small heat sinks 2. The tank 3 is partially filled with a fluorocarbon liquid 11. This tank 3 is linked to an upper part,termed a manifold 5 of the chamber 10 via channels 12 which pass through a heat exchanger section 4. A small valve 6 is placed at the top of the manifold 5 so as to permit the fluorocarbon liquid to enter the chamber 10 during the initial filling stage.

In use, other circuit components associated with the high power semiconductor component 1 will also be mounted within the tank 3 and these components will consist of items such as firing transformers and associated circuits. In this instance the heat exchanger 4 takes the form of a finned radiator which dissipates the heat from the channels 12 to the atmosphere in an efficient manner.

In operation, when the chamber 10 is correctly filled such that it contains only fluorocarbon liquid and its vapour, power is applied to the semiconductor component 1 causing it to dissipate a great deal of heat. This heat causes the temperature of the fluorocarbon liquid to rise above its boiling point and to generate extra vapour 13 which rises through the channels 12 to the manifold 5. As the vapour rises through the radiator section 4 it is cooled and it therefore condenses readily, the condensed liquid running back through the channels 12 to the tank 3.

A fluorocarbon liquid known as Freon 11, which is a typical fluorocarbon boils at a temperature of 23.8°C at atmospheric pressure. At temperatures above this value and in an enclosed system as illustrated in the drawing, a pressure will be built up within the system in accordance with known pressure/temperature curves. The operation of the cooling system is essentially isothermal. This means that in steady state conditions (i.e. no transient power inputs) both the liquid and the vapour will be essentially at the same temperature. Thus a temperature measurement made on the side of the tank 3 should be within l°C or 2°C of a measurement made at the top of radiator 4. If this is so, then the system is operating correctly and it is found that the chamber is correctly filled with the fluorocarbon liquid and vapour. However, it has been found that the system does not always operate correctly, in that a significant temperature difference can exist between the tank 3 and the condensation chamber 5. This impaired operation is due to the presence of another gas such as air within the system.

Thus, if the channels 12 passing through the radiator 4 are partially filled with air this reduces the partial pressure of the fluorocarbon vapour and lowers its temperature. A temperature differential of up to 10°C has been noted and this is a clear indication of the presence of gas such as air. This temperature difference is sensed by the temperature sensors 14 and 15 positioned on the tank 3 and at the top of the radiator 4. The outputs of the temperature sensors are fed to a temperature comparator 16 which is operative to provide an indication of an excessive temperature difference.

When a sufficiently large temperature difference is detected at the comparator 16 which is indicative of air in the system the unwanted air may be ejected by raising the temperature of the flurocarbon above its boiling temperature, i.e. above 23.8°C in the case of Freon 11 , and opening the valve 6. On opening the valve the temperature measured at the top of the radiator by the sensor 14 will rise steadily as the air is removed until it is within l°C or 2°C of the value measured on the tank body by the sensor 15. This reduction in temperature difference is due to the Freon vapour entering the region previously blanketed by air and establishing an isothermal region throughout the system. When all of the air has been removed via the valve 6, fluorocarbon vapour will start escaping from the chamber 10, and will produce a cooling effect causing the temperature measured at the sensor 21 to start dropping again. The valve 6 is then closed.

The output signal of the temperature comparator is fed to a control circuit 17 which is operative to open and close the valve 6, so that the operation of the system can be fully automatic.

By the inclusion of a signal 10 relating to ambient air temperature the assessment of the system can be extended to indicate that at low ambient temnperatures although the system does contain air and is therefore degraded, the overall system is still viable and would only need to be shut down if the ambient air temperature rises to a dangerous level.

## Claims

1. A cooling arrangement of the phase change kind including a chamber, a lower portion of which contains a liquid to which heat can be applied to vaporise some of the liquid and an upper portion of which constitutes a condensation region at which vaporised liquid is condensed, and means for monitoring a difference in temperature between the upper and lower portions and which is indicative of an incomplete filling of the chamber with said liquid and its vapour.

2. An arrangement as claimed in claim 1 and wherein the liquid is fluorocarbon.

3. An arrangement as claimed in claim 1 or 2 and wherein a heat exchange section is placed between the lower part of the chamber and the upper part.

4. An arrangement as claimed in claim 3 and wherein the heat exchange section includes a finned radiator.

5. An arrangement as claimed in any of the preceding claims and wherein the lower portion of the chamber is adapted to hold a component or body to be cooled.

6. An arrangement as claimed in any of the preceding claims and wherein respective temperature sensors are located at the upper and lower portions of the chamber, with the outputs of the sensors being compared so as to give an indication of the temperature difference between the upper and lower chambers.

7. An arrangement as claimed in claim 6 and wherein means are provided for venting the upper chamber when the temperature difference exceeds a certain value, so as to remove unwanted gas from the chamber.

8. A method of monitoring the operation of a phase change cooling arrangement including the step of determining whether the temperature difference between a heating region of a volatile liquid and a condensation region of gas exceeds a predetermined value.

9. A method as claimed in claim 8 and wherein the upper chamber is vented when the predetermined value is exceded, so as to vent unwanted gas.

10. A method as claimed in claim 9 and wherein venting continues whilst the temperature difference decreases, and the venting is discontinued when the temperature difference begins to increase again as vapour of the volatile liquid begins to escape.